(19) Europäisches Patentamt
European Patent Office
Office européen des brevets

(11) **EP 3 713 726 B1**

(12) **FASCICULE DE BREVET EUROPEEN**

(45) Date de publication et mention
de la délivrance du brevet:
**27.10.2021 Bulletin 2021/43**

(21) Numéro de dépôt: **18825751.3**

(22) Date de dépôt: **20.11.2018**

(51) Int Cl.:
*B26D 7/22* (2006.01)   *B26B 15/00* (2006.01)
*A01G 3/00* (2006.01)   *A01G 3/037* (2006.01)
*B26D 7/24* (2006.01)   *F16P 3/20* (2006.01)
*F16P 3/12* (2006.01)   *H03K 17/96* (2006.01)

(86) Numéro de dépôt international:
**PCT/FR2018/052914**

(87) Numéro de publication internationale:
**WO 2019/102129 (31.05.2019 Gazette 2019/22)**

(54) **OUTIL DE COUPE ÉLECTRIQUE À ARRÊT D'URGENCE AUTOMATIQUE**

ELEKTRISCHE SCHNEIDVORRICHTUNG MIT AUTOMATISCHEM NOTSTOPP

ELECTRIC CUTTING DEVICE WITH AUTOMATIC EMERGENCY STOP

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.11.2017 FR 1771255**

(43) Date de publication de la demande:
**30.09.2020 Bulletin 2020/40**

(73) Titulaire: **Pellenc
84120 Pertuis (FR)**

(72) Inventeurs:
• PELLENC, Roger
84120 Pertius (FR)
• LOPEZ, Bernard
84240 La Tour D'Aigues (FR)

(74) Mandataire: **Weber, Etienne Nicolas
Cabinet Marek
28, rue de la Loge
Boîte Postale 42413
13201 Marseille Cedex 02 (FR)**

(56) Documents cités:
**EP-B1- 2 825 811   WO-A1-2012/025456**

## Description

### Domaine technique

La présente invention concerne un outil de coupe sécurisé à commande électrique pourvu d'un dispositif d'arrêt d'urgence automatique. Le dispositif d'arrêt d'urgence vise à empêcher une blessure grave d'un utilisateur de l'outil de coupe en cas de contact inopiné de l'utilisateur avec un organe de coupe de l'outil de coupe, lorsque l'outil est en fonctionnement. Pour le moins, l'invention vise à limiter une éventuelle blessure à une blessure légère

Une blessure grave est caractérisée, par exemple, pour un sécateur électrique, par une coupe profonde, voire la section complète d'une partie d'un doigt de l'utilisateur. Une blessure légère peut, en revanche, être comparée à une griffure de l'épiderme de la main dans des ronces pouvant générer un léger écoulement de sang.

Le dispositif d'arrêt d'urgence est considéré comme étant automatique si l'arrêt d'urgence est déclenché sans intervention volontaire de l'utilisateur, mais à la simple détection d'une situation de risque de blessure.

L'invention peut trouver des applications pour différents outils de coupe, et en particulier pour des outils de coupe électroportatifs à lame mobile, tels que des sécateurs ou des cisailles, voire des tronçonneuses, des scies circulaires, des perceuses ou des meuleuses.

### Etat de la technique antérieure

Une illustration de l'état de la technique est donnée par les documents suivants :

FR2 712 837
FR2 779 669
FR2 831 476
FR2 838 998
FR2 846 729
FR2 963 081
FR3 001 404
EP2 490 865
EP2 825 811: ce document montre un sécateur avec un système de sécurité pourvu d'une électrode de contact manuel sur la poignée, selon le préambule de la revendication 1.
US5 025 175
US7 365 955
WO 2012/025456: ce document montre une tronçonneuse avec un système de sécurité capacitif pourvu d'une électrode de contact sur la poignée.

Les documents précités concernent des machines et des outils à commande électrique pourvus d'un dispositif d'arrêt d'urgence pour éviter qu'un utilisateur ne se blesse. Parmi ces documents on peut constater de nombreux outils comme des sécateurs électriques tenus à une seule main pour couper de la végétation.

Dans cet exemple, les utilisateurs tiennent le sécateur électrique à une main et utilisent leur deuxième main, libre, pour la manipulation des végétaux coupés ou à couper. Un risque de blessure existe alors lorsque la main qui ne tient pas le sécateur vient à proximité immédiate ou en contact avec l'organe de coupe lors de la coupe. Dans le cas des sécateurs ou des cisailles, l'organe de coupe, se présente majoritairement sous la forme d'une lame fixe, ou crochet, et d'une lame pivotante. La lame pivotante pivote entre une position ouverte et une position refermée sur le crochet, avec un effet de cisaillement entre la lame pivotante et le crochet. L'organe de coupe de certains sécateurs peut aussi comporter deux lames mobiles coopérant entre elle pour réaliser l'effet de cisaillement lorsque les lames passent d'une position ouverte à une position refermée.

Dans le cas des perceuses, des meuleuses, des scies circulaires ou des tronçonneuses, l'organe de coupe présente des parties tranchantes en rotation autour d'un axe.

Dans le cas de machines-outils telles que des cisailles, des broyeurs ou des scies circulaires, des organes de coupe se présentent sous la forme de parties tranchantes en rotation autour d'un axe ou en translation par rapport à un bâti fixe.

Différents moyens sont mis en œuvre pour détecter la proximité immédiate ou le contact de la main avec l'organe de coupe. On peut distinguer notamment des moyens radioélectriques, des moyens à détection de potentiel sur la lame, des moyens capacitifs ou encore des moyens à mesure d'impédance.

Les dispositifs de sécurité connus mettent en œuvre des gants, des chaussures ou encore une balise, reliés électriquement au dispositif de sécurité par un lien de communication. Le lien peut être un lien par fil ou éventuellement par voie hertzienne.

Lorsque des gants sont utilisés, les gants sont pourvus de conducteurs électriques et ont pour fonction de créer un circuit de mesure entre le gant et l'organe de coupe. Similairement, des chaussures conductrices peuvent être utilisées pour créer un circuit de mesure relié à la terre et incluant le corps de l'utilisateur.

L'utilisation de balises électroniques, de gants conducteurs, de chaussures conductrices, ou plus généralement d'un vêtement conducteur reliés électriquement à l'outil de coupe, permet de détecter un contact de l'utilisateur avec l'organe de coupe. Un arrêt d'urgence de l'opération de coupe, en réponse, par exemple, à la détection du contact du vêtement conducteur avec l'organe de coupe, permet d'éviter ou de limiter la gravité d'une blessure éventuelle.

Les dispositifs de sécurité connus présentent cependant un certain nombre de difficultés ou d'inconvénients pour l'utilisateur. Parmi celles-ci on peut relever notamment :

- la gêne occasionnée par le port de vêtements conducteurs, et en particulier de gants conducteurs,
- la gêne occasionnée par un lien filaire entre les vêtements conducteurs et le sécateur,
- un risque de sectionner le lien filaire entre le vêtement conducteur et le sécateur,
- un risque de blessure en cas d'oubli du port du vêtement conducteur ou de la balise de détection, ou d'un port inadéquat de ces accessoires.
- un risque lié à la défaillance des contacts entre le dispositif de sécurité et l'organe de coupe. Par exemple, l'usure des gants conducteurs suite à une trop longue utilisation, un mauvais entretien, une détérioration accidentelle, voire le dépôt de substances isolantes au niveau du gant ou de l'organe de coupe, telles que de la sève, de l'huile ou de la graisse, risquent de modifier voire d'occulter le signal perçu par le dispositif de sécurité. Ceci peut, à court terme, rendre inopérant le dispositif de sécurité sans que l'utilisateur ne s'en rende compte au préalable.

**Exposé de l'invention**

La présente invention a pour but de proposer un outil de coupe sécurisé qui ne présente pas les inconvénients mentionnés ci-dessus.

En effet, l'invention a pour but de proposer un outil de coupe sécurisé qui ne fasse pas appel à un vêtement conducteur électrique tel qu'un gant et qui ne nécessite pas le port d'une balise.

L'invention propose un outil de coupe comportant un dispositif de sécurité qui utilise simplement la conductivité du corps de l'utilisateur à proximité immédiate ou en contact avec celui-ci, pour détecter l'existence d'un contact entre l'utilisateur et l'organe de coupe, et ainsi prévenir d'un risque de blessure.

L'utilisation de la simple conductivité du corps humain, mesurable par son impédance notamment, présente cependant des difficultés tenant à la qualité de contact électrique entre le corps de l'utilisateur et le dispositif de sécurité ou l'organe de coupe. L'impédance intrinsèque du corps humain est en effet de faible valeur, dépendant de l'utilisateur et ne variant pas de façon significative. Tel n'est pas le cas d'une impédance de contact entre le corps de l'utilisateur et une partie conductrice comme, par exemple, une électrode de contact manuel ou le tranchant d'une lame de coupe conductrice. Cette impédance est susceptible en effet de varier dans des proportions importantes. Elle peut varier selon les caractéristiques de la peau de l'utilisateur, selon le fait que la peau soit mouillée ou non, selon les caractéristiques de surface d'une l'électrode de contact manuel (dimensions, rugosité, conductivité...), selon les conditions climatiques ou encore selon une pression de contact exercée par l'utilisateur.

Par exemple, une main avec une peau sèche a une très faible conductivité. Son contact, avec une faible pression, sur une électrode de contact manuel peut générer une grande impédance de contact pouvant atteindre des valeurs de quelques centaines de milliers d'Ohms. A l'inverse, le contact avec une main humide, notamment en atmosphère saline en bord de mer, apporte une faible impédance de contact de quelques milliers d'Ohms, voire seulement quelques centaines d'Ohms ou même quelques Ohms.

Le contact d'une partie du corps d'un utilisateur avec l'organe de coupe, peut se traduire par une valeur d'impédance de quelques Ohms voire quelques centaines d'Ohms selon la pression de contact exercée s'il a lieu par exemple dans une zone très conductrice et coupante comme le tranchant de la lame d'un sécateur. En revanche, la valeur d'impédance peut être de quelques centaines d'Ohms, voire de quelques milliers d'ohms, ou plus, si le contact a lieu sur une autre partie de l'organe de coupe, par exemple sur le côté d'une lame de coupe possédant un revêtement isolant mince.

Ces aléas, peuvent être obviés par l'usage d'un vêtement et/ou d'un lien filaire conducteur électrique aboutissant à une impédance de contact ne variant que sur une faible plage de valeurs. Si ce n'est le cas, ils doivent être pris en compte de manière à ne pas compromettre la sécurité de l'outil de coupe.

En effet, le contact d'un utilisateur simultané avec un dispositif de sécurité et un organe de coupe peut générer une très grande plage de valeurs d'impédances possibles entre l'organe de coupe et l'outil comportant le dispositif de sécurité. Il n'est pas possible, dans ce cas, d'établir de façon fiable le risque d'un contact réel entre l'utilisateur et l'organe de coupe.

Pour surmonter ces difficultés, la présente invention propose un outil de coupe sécurisé comprenant:

- un organe de coupe conducteur électrique,
- un moteur d'actionnement de l'organe de coupe, commandé électriquement,
- une poignée de saisie de l'outil de coupe par la main d'un utilisateur, la poignée de saisie étant électriquement isolée de l'organe de coupe,
- un organe de déclenchement de coupe actionnable par la main de l'utilisateur saisissant la poignée de saisie, l'organe de déclenchement de coupe étant électriquement isolé de l'organe de coupe,
- un dispositif d'arrêt d'urgence sensible à un contact d'un utilisateur avec l'organe de coupe,

Conformément à l'Invention, l'outil de coupe sécurisé se caractérise par:

- au moins une première et au moins une deuxième d'électrode de contact manuel, la première électrode de contact manuel et la deuxième électrode de contact manuel étant électriquement isolées l'une de l'autre, et ménagées sur au moins l'une de la poignée de saisie de l'outil et l'organe de déclenchement de coupe, de manière à être touchées simultanément par la main de l'utilisateur lorsqu'il saisit la poignée de saisie,

- un circuit électrique de surveillance comprenant la première électrode de contact manuel et l'organe de coupe, le circuit électrique de surveillance étant susceptible d'être fermé, lors d'un contact simultané de l'utilisateur avec ladite première électrode de contact manuel et avec l'organe de coupe,
- un générateur électrique d'un courant de surveillance dans le premier circuit électrique,
- un dispositif de mesure d'une tension de surveillance entre l'organe de coupe et la deuxième électrode de contact manuel,
- un comparateur d'au moins une caractéristique électrique de surveillance fonction de la tension de surveillance et d'une caractéristique électrique de seuil fonction d'une valeur d'impédance majorant une valeur d'impédance de conduction du corps humain, le comparateur étant relié au dispositif d'arrêt d'urgence du moteur d'actionnement de l'organe de coupe, pour provoquer un arrêt d'urgence lorsque la caractéristique électrique de surveillance franchit la caractéristique électrique de seuil.

L'outil de coupe de l'invention peut être l'un parmi un sécateur, une cisaille, une perceuse, une meuleuse, une scie circulaire, une tronçonneuse ou tout autre outil ou machine-outil possédant un organe de coupe à sécuriser. Une mise en œuvre de l'invention est envisagée en particulier pour des sécateurs. Toutefois, la mention d'un sécateur dans la description qui suit, par commodité de langage ou par simplification, ne préjuge pas de la nature de l'outil de coupe.

La poignée de saisie et l'organe de déclenchement de coupe sont considérés comme électriquement isolés de l'organe de coupe, lorsqu'au moins une partie de la poignée et de l'organe de déclenchement de coupe, et notamment celle portant les électrodes de contact manuel, susceptible d'être touchée par l'utilisateur lorsqu'il saisit la poignée de saisie ou actionne l'organe de déclenchement de coupe, est électriquement isolée de l'organe de coupe. On considère que c'est également le cas lorsque la poignée ou l'organe de déclenchement de coupe est reliée à l'organe de coupe par l'intermédiaire d'une impédance dépassant de plusieurs ordres de grandeurs la valeur des impédances en jeu dans le fonctionnement de l'outil et le déclenchement de l'arrêt d'urgence, par exemple une valeur de plusieurs millions d'Ohms.

Les électrodes de contact manuel peuvent être des électrodes métalliques, conductrices électriques, ou peuvent être formées par des plages de matière plastique de la poignée ou de la gâchette, également conductrices électriques. Il s'agit, par exemple, d'électrodes faites d'un polymère conducteur intrinsèque tel que le PolyPyrolle, ou d'une matière plastique conductrice extrinsèque chargée, par exemple, de particules de carbone ou d'argent.

Bien que la description se réfère à deux électrodes, un nombre plus grand d'électrodes de contact manuel peut être utilisé. Dans la suite de la description, une référence à la première ou à la deuxième électrode de contact manuel ne préjuge pas du caractère unique ou multiple de chacune de ces électrodes. L'utilisation de plusieurs premières électrodes de contact manuel et de plusieurs deuxièmes électrodes de contact manuel peut être envisagée notamment pour améliorer un contact électrique avec la main de l'utilisateur.

Le moteur d'actionnement peut être un moteur électrique ou éventuellement un moteur thermique à commande électrique. Dans une mise en œuvre préférée de l'invention il s'agit toutefois d'un moteur électrique. Il peut s'agir notamment d'un moteur électrique piloté par une carte électronique capable de commander des fonctions de rotation dans un sens et dans un sens opposé, et éventuellement des fonctions de freinage électromagnétique.

L'organe de déclenchement de coupe peut être par exemple une gâchette, ou un organe avec ou sans contact, tel qu'un capteur optique mesurant la position d'un doigt d'actionnement de l'utilisateur. L'organe de déclenchement est situé sur la poignée de saisie ou au voisinage de la poignée, de manière à pouvoir être actionné par la main de l'utilisateur saisissant la poignée de saisie. L'organe de déclenchement de coupe permet notamment de mettre en fonctionnement le moteur d'actionnement, et provoquer, par exemple l'ouverture ou la fermeture de l'organe de coupe d'un sécateur.

Le dispositif d'arrêt d'urgence est un dispositif capable d'opérer un arrêt instantané de l'outil de coupe, et notamment de l'organe de coupe, pour éviter une blessure de l'utilisateur ou pour éviter l'aggravation d'une blessure naissante. L'arrêt d'urgence peut comporter le déclenchement immédiat de l'une des opérations suivantes :

- la coupure de l'alimentation du moteur d'actionnement, en particulier son alimentation électrique, dans le cas d'un moteur d'actionnement électrique,
- un freinage d'urgence agissant sur le moteur d'actionnement et/ou directement sur l'organe de coupe
- le déclenchement d'un mouvement d'urgence de l'outil de coupe, tel que, par exemple, l'ouverture de l'organe de coupe, dans le cas d'un sécateur ou d'une cisaille, ou un mouvement de compensation de l'inertie cinétique des pièces mobiles de l'organe de coupe.

Le dispositif d'arrêt d'urgence peut notamment comprendre un frein.

Il peut s'agir d'un frein électromagnétique agissant sur le moteur, sur un volant du moteur ou directement sur l'organe de coupe.

Lorsque le moteur d'actionnement est un moteur électrique, le freinage, électromagnétique, le déclenchement d'un mouvement d'urgence, voire la simple coupure de l'alimentation électrique, peuvent avoir lieu simplement par l'intermédiaire de la carte électronique de commande du moteur en pilotant l'alimentation électrique des phases du moteur. Dans ce cas, le dispositif d'arrêt d'urgence comprend la carte électronique de pilotage du moteur.

Le dispositif de mesure d'une tension de surveillance entre l'organe de coupe et la deuxième électrode de contact manuel est un dispositif de mesure à haute impédance, tel qu'un voltmètre. Son impédance interne est supérieure de plusieurs ordres de grandeur aux impédances en jeu dans le circuit électrique de surveillance, de manière à ne pas perturber un courant circulant dans le circuit électrique de surveillance. Il s'agit, par exemple d'une impédance interne supérieure à 10MΩ. La tension de surveillance est mesurée par rapport au potentiel de l'organe de coupe qui correspond, de préférence au potentiel de masse de l'outil. Elle peut également être mesurée ou déterminée par rapport à un potentiel fixe par rapport à la masse ou par rapport à l'organe de coupe.

La caractéristique électrique de surveillance peut être une caractéristique pouvant être exprimée sous la forme d'une tension, d'un courant, d'une valeur d'Impédance ou encore d'une valeur de conductance. Elle est établie à partir de la tension de surveillance, en application de la loi d'Ohm.

Il en va de même pour la caractéristique de seuil, qui est établie à partir de l'impédance de conduction du corps humain et en particulier une valeur majorant une valeur d'impédance du corps humain. Elle peut également être établie sous la forme d'une tension, d'un courant, d'une valeur d'impédance ou d'une valeur de conductance, en application de la loi d'Ohm et d'une valeur d'impédance du circuit électrique.

Différentes formes d'expression de la caractéristique électrique de surveillance et de la caractéristique électrique de seuil sont explicitées dans la suite de la description.

Le circuit électrique de surveillance comprend, comme mentionné précédemment, la première électrode de contact manuel, et l'organe de coupe conducteur électrique. Il est fermé lorsque l'utilisateur touche à la fois la première électrode de contact manuel de l'outil de coupe et l'organe de coupe.

Par simplification, on considère que l'utilisateur touche la première électrode de contact manuel avec l'une de ses mains qui saisit la poignée, et qu'il touche l'organe de coupe avec un doigt de l'autre main, qui risque en l'occurrence d'être blessé. Ce choix n'implique cependant aucune limitation quant à la partie du corps qui touche l'organe de coupe. Le fonctionnement et le déclenchement du dispositif d'arrêt d'urgence est identique quelle que soit la partie du corps humain qui entre en contact avec l'organe de coupe. Il peut s'agir d'un doigt, de la main, de la jambe, ou de l'avant-bras, par exemple.

Ainsi, lorsque l'utilisateur touche simultanément la première électrode de contact manuel et l'organe de coupe, un certain nombre d'impédances se trouvent en série dans le circuit de mesure entre la première électrode de contact manuel et l'organe de coupe. Il s'agit :

- de l'impédance de contact entre la main et la première électrode de contact manuel, notée $Z_{M1}$
- de l'impédance du corps de l'utilisateur, entre la main touchant la première électrode de contact manuel et le doigt de l'autre main, notée $Z_C$, et
- de l'impédance de contact entre le doigt et l'organe de coupe, notée $Z_D$.

Par ailleurs, dans le cas particulier d'un sécateur, on note $Z_V$, la somme de l'Impédance de la végétation, par exemple celle de sarments de vigne, et de l'impédance de contact du doigt, ou plus généralement de la main, sur la végétation ou un objet tenu par la main libre de l'utilisateur et coupés par l'organe de coupe. L'objet tenu peut être, le cas échéant un fil de fer de palissage. Pour d'autres outils la grandeur $Z_V$ caractérise l'impédance du matériau coupé associée au contact du doigt avec ce matériau, dans l'hypothèse où ce matériau est touché par la main libre de l'utilisateur.

En négligeant les valeurs d'impédance propres de la première électrode de contact manuel et de l'organe de coupe, l'impédance totale notée $Z_T$ du circuit électrique de surveillance pourra prendre trois valeurs :

- une valeur infinie $Z_T=\infty$, lorsque l'organe de coupe n'est pas touché,
- une valeur $Z_T=Z_{M1}+Z_C+Z_D$ lorsque le doigt touche l'organe de coupe,
- une valeur $Z_T=Z_{M1}+Z_C+Z_V$ lorsqu'un matériau tenu par la main libre touche l'organe de coupe.

L'ordre de grandeur de la valeur de l'impédance $Z_C$ du corps de l'utilisateur, entre sa première main amenée à saisir la poignée et son doigt de l'autre main susceptible de toucher l'organe de coupe, peut aisément être évalué. Il s'agit de la conductivité du corps humain dont l'impédance a une valeur inférieure à dix mille Ohms, et en tous cas d'un ordre de grandeur de mille Ohms.

La valeur de l'impédance $Z_{M1}$ de contact de la main avec la première électrode de contact manuel, ainsi que la valeur de l'impédance de contact $Z_D$ entre le doigt et l'organe de coupe, ou l'impédance $Z_V$ comprenant l'impédance intermédiaire d'un matériau en contact avec l'organe de coupe peuvent présenter une grande variabilité et sont le plus souvent très supérieures à la valeur de l'impédance du corps de l'utilisateur, notamment en cas de pression de contact faible avec une partie de peau de la main ayant une faible conductivité.

Dans la suite de la description, il n'est fait référence qu'au contact direct du doigt avec l'organe de coupe. En effet, la situation du contact du doigt avec un matériau intermédiaire ne génère pas de risque pour l'utilisateur. Elle peut éventuellement déclencher le dispositif d'arrêt d'urgence lorsqu'une valeur d'impédance $Z_V$ est proche de $Z_D$, c'est-à-dire lorsque le matériau intermédiaire est bon conducteur électrique.

Cependant, quand le contact du doigt avec l'organe de coupe est proche d'un risque de blessure, les différents essais conduits par la déposante montrent que la valeur de l'impédance de contact du doigt $Z_D$ peut être évaluée comme étant du même ordre de grandeur voire devenir inférieure à la valeur de l'impédance $Z_C$ du corps de l'utilisateur. En effet, le doigt présente une élasticité importante lorsque la lame vient à son contact et ce n'est qu'avec une pression significative que la lame peut d'abord couper l'épiderme du doigt provoquant une blessure légère avant d'effectuer une blessure grave en poursuivant la coupe. Lors d'une coupure légère, comme une griffure au niveau de l'épiderme, la valeur de l'impédance de contact $Z_D$ entre l'organe de coupe et les parties sous-cutanées du doigt est alors très inférieure à la valeur de l'impédance du corps humain $Z_C$.

On estime que la valeur de l'impédance de contact au niveau de l'organe de coupe en cas de contact sérieux est Inférieure à la valeur de l'impédance du corps humain. Une détection d'une impédance de l'ordre de grandeur de l'impédance du corps humain permet alors d'identifier avec une très grande probabilité l'existence d'un contact instantané et non souhaité de l'utilisateur avec l'organe de coupe.

Il n'en est pas de même de l'impédance de contact $Z_{M1}$ entre la main de l'utilisateur et de la première électrode de contact manuel, dont la valeur peut varier dans des proportions plus importantes, et masquer de fait l'occurrence d'un contact entre le doigt de l'utilisateur et l'organe de coupe.

Le dispositif de mesure de l'invention permet de s'affranchir de l'impédance de contact $Z_{M1}$ entre la main de l'utilisateur et la première électrode de contact manuel. Ceci a lieu en mesurant une tension sur la deuxième électrode de contact manuel.

La deuxième électrode de contact manuel est reliée à la première électrode de contact manuel par l'intermédiaire de la main de l'utilisateur qui saisit la poignée et qui touche de ce fait la première et la deuxième électrode de contact manuel. Les électrodes de contact manuel sont ainsi reliées par deux impédances potentiellement élevées en série. Il s'agit de l'impédance $Z_{M1}$ de contact de la main avec la première électrode de contact manuel et d'une impédance $Z_{M2}$ de contact de la main avec la deuxième électrode de contact manuel.

Ainsi on considère également que la deuxième électrode de contact manuel est reliée à l'Impédance du corps de l'utilisateur par l'impédance de contact de la main avec la deuxième électrode de contact manuel. En raison de l'impédance interne élevée du dispositif de mesure de tension, la tension $V_{E2}$ mesurée sur la deuxième électrode de contact manuel, ou plus précisément la différence de potentiel entre cette électrode et la masse de l'outil est sensiblement égale à une différence de potentiel Vc qui serait mesurée en un point fictif interne de la main de l'utilisateur noté C et l'organe de coupe relié à la masse de l'outil. En effet un courant nul ou quasi nul circule entre ce point fictif interne et la deuxième électrode de contact manuel assurant la quasi égalité des potentiels $V_{E2}$ et Vc, ces deux tensions pouvant être considérées comme constituant la tension de surveillance.

Le générateur électrique d'un courant de surveillance a pour fonction de faire circuler dans le circuit de surveillance un courant de surveillance $I_s$, lorsque le circuit de surveillance est fermé, c'est à dire lors d'un contact, direct ou indirect, de l'utilisateur avec l'organe de coupe.

Le générateur électrique peut comporter, par exemple, une source de courant. Il peut aussi comporter une source de tension. La source de courant ou la source de tension peuvent être connectées en série dans le circuit de surveillance.

Le générateur électrique du courant de surveillance peut disposer d'une alimentation autonome, par exemple une pile électrique. Il peut aussi être alimenté en énergie par une source d'alimentation électrique, par exemple une batterie d'alimentation, de l'outil de coupe, lorsque l'outil de coupe est un outil pourvu d'un moteur d'actionnement électrique.

Lorsque le générateur électrique comporte une source de courant, l'intensité du courant lorsque le circuit est fermé est connue. Elle correspond alors à l'intensité du courant de surveillance $I_s$.

L'outil de coupe peut aussi comporter, en série dans le circuit électrique une impédance électrique d'ajustement présentant une valeur d'impédance prédéterminée et connue $Z_1$ ainsi qu'un dispositif de mesure d'une tension $V_1$ aux bornes de l'impédance électrique d'ajustement. La mesure de cette tension permet alors également de connaitre l'intensité du courant de surveillance $I_s$. En effet le courant de surveillance $I_s$ est égal au rapport de la tension mesurée aux bornes de l'impédance électrique d'ajustement sur la valeur de l'impédance électrique d'ajustement :

$$I_s = V_1 / Z_1$$

Le choix de la valeur de l'impédance d'ajustement $Z_1$, est susceptible d'influencer l'intensité du courant circulant dans le circuit de surveillance. Elle n'est pas critique toutefois, sa fonction étant essentiellement de déterminer l'intensité du courant de surveillance. Par exemple, la valeur de l'impédance d'ajustement peut être choisie entre $1\Omega$ et $200k\Omega$.

Le dispositif de mesure est, par exemple un voltmètre, et en particulier un voltmètre intégré à une carte électronique comprenant en outre le comparateur.

Il est ainsi possible de connaître l'impédance Z cumulée du corps de l'utilisateur à partir de la mesure de $V_{E2}$ et du courant de surveillance Is circulant dans le circuit électrique de surveillance.

On a:

$$Z = Z_C + Z_D$$

et

$$V_{E2} = I_S \times Z.$$

Soit :

$$Z = V_{E2} / I_S$$

Cette impédance peut être comparée à une valeur d'impédance de seuil $Z_{seuil}$ majorant la valeur d'impédance $Z_C$ du corps humain, et majorant de préférence d'un facteur 3 la valeur d'impédance $Z_C$ du corps humain. En particulier la valeur majorant l'impédance peut être choisie égale à 20k$\Omega$, et de préférence supérieure à 100k$\Omega$. Elle prend ainsi en compte, en outre, une valeur de contact entre le doigt de l'utilisateur et l'organe de coupe peu susceptible de générer une blessure lors de l'actionnement de l'organe de coupe.

Selon une mise en œuvre particulière de l'invention, la caractéristique électrique de surveillance peut être une tension fonction de la tension de surveillance et la caractéristique électrique de seuil peut être une tension de seuil fonction de la valeur d'impédance $Z_{seuil}$ majorant une valeur d'impédance de conduction du corps humain et du courant de surveillance. En particulier, la caractéristique électrique de surveillance peut être égale à la tension de surveillance $V_{E2}$ et la caractéristique électrique de seuil peut être égale à une tension $V_{seuil}$ égale au produit de la valeur d'impédance majorant une valeur d'impédance de conduction du corps humain et du courant de surveillance.

On compare dans ce cas $V_{E2}$ et $V_{seuil}$
où $V_{seuil} = Z_{seuil} \times I_S$
Lorsque $V_{E2} > V_{seuil}$ le fonctionnement de l'outil est normal.

Lorsque $V_{E2} < V_{seuil}$ ou $V_{E2} = V_{seuil}$, le dispositif d'arrêt d'urgence est déclenché.

Selon une autre possibilité de mise en œuvre particulière, la caractéristique électrique de surveillance peut être une valeur d'impédance fonction de la tension de surveillance et du courant de surveillance, et la caractéristique de seuil peut être une valeur d'impédance fonction de la valeur d'impédance $Z_{seuil}$ majorant une valeur d'impédance de conduction du corps humain.

En particulier, la caractéristique électrique de surveillance peut être égale à une impédance $Z$ égale au rapport de la tension de surveillance sur le courant de surveillance, et la caractéristique de seuil peut être égale à la valeur d'impédance $Z_{seuil}$ majorant une valeur d'Impédance de conduction du corps humain.

Dans ce cas lorsque $Z > Z_{seuil}$ le fonctionnement de l'outil est normal.

En revanche lorsque lorsque $Z < Z_{seuil}$ ou $Z = Z_{seuil}$, le dispositif d'arrêt d'urgence est déclenché.

D'autres caractéristiques de surveillance et de seuil comme des fonctions affines des grandeurs précitées peuvent également être retenues. Il est encore possible de comparer des conductances.

La comparaison entre l'impédance $Z$ et l'impédance $Z_{seuil}$, ou, comme évoqué précédemment, la comparaison de la tension de surveillance $V_{E2}$ avec une tension $V_{seuil}$, ou encore, plus généralement la comparaison d'une autre caractéristique électrique de surveillance, fonction de la tension de surveillance, avec une caractéristique électrique de seuil, fonction d'une impédance majorant l'impédance du corps humain, est effectuée par le comparateur.

A cet effet, la valeur $Z_{seuil}$, la valeur $V_{seuil}$, ou plus généralement la valeur d'une caractéristique électrique de seuil fonction d'une impédance majorant l'impédance du corps humain, peut être stockée dans une mémoire reliée au comparateur. Les valeurs de seuil contenues dans la mémoire peuvent être fixées à la fabrication de l'outil. Un accès à la mémoire peut également être prévu pour modifier les valeurs de seuil de manière à modifier, au besoin, la sensibilité du déclenchement du dispositif d'arrêt d'urgence.

Lorsque le générateur électrique comporte une source de courant, celle-ci peut être connectée en parallèle à l'impédance d'ajustement, connectée en série dans le circuit électrique de surveillance. Comme mentionné précédemment, la loi d'Ohm permet alors de déterminer la valeur Is du courant circulant dans le circuit de surveillance.

Le générateur électrique peut être un générateur à courant alternatif ou un générateur à courant continu. Un générateur à courant alternatif présente, par exemple, une fréquence de fonctionnement de 10kHz. L'utilisation d'un courant de surveillance alternatif permet au dispositif de fonctionner lorsque l'organe de coupe, conducteur, est recouvert d'une couche mince d'isolant électrique, par exemple une couche anticorrosion ou une couche anti-salissures. Par exemple, la lame d'un sécateur peut être recouverte d'un fin revêtement en PTFE de façon à faciliter son glissement sur la contre-lame lors de la coupe tout en évitant sa corrosion. En effet, dans ce cas, le contact entre le doigt de l'utilisateur et l'organe de coupe peut être un contact majoritairement capacitif. Il faut noter ici toutefois que le tranchant de la lame est affranchi de ce type de revêtement, le tranchant de la lame étant trop effilé pour qu'un tel revêtement protecteur y adhère.

L'outil de coupe peut comporter en outre un dispositif de surveillance d'un potentiel électrique de l'organe de coupe. Le dispositif de surveillance du potentiel électrique est relié au dispositif d'arrêt d'urgence pour provoquer un arrêt d'urgence lorsque le potentiel électrique de l'organe de coupe est hors d'une plage de consigne. Le dispositif de surveillance permet d'éviter des situations dans lesquelles l'établissement des caractéristiques électriques de surveillance serait affecté par un potentiel modifié de l'organe de coupe, et en particulier par un potentiel non nul de l'organe de coupe.

En effet, et de la manière déjà évoquée, l'organe de coupe est relié de préférence à un potentiel de masse de l'outil.

Une modification du potentiel de l'organe de coupe peut résulter, par exemple, lors d'un contact inopiné de l'organe de coupe avec un conducteur métallique sous tension, tel qu'une clôture électrique, par exemple.

Accessoirement l'outil de coupe peut comporter une impédance de mise à la masse, d'une valeur dépassant de plusieurs ordres de grandeur la valeur d'impédance majorant la valeur d'impédance du corps humain, l'impédance de mise à la masse reliant électriquement la deuxième électrode de contact manuel à l'organe de coupe. Dans ce cas, l'outil de coupe peut être configuré pour provoquer en outre l'un parmi un arrêt d'urgence et une mise hors service, lorsque la tension de surveillance mesurée par le dispositif de mesure est nulle. L'impédance de mise à la masse permet d'éviter un potentiel flottant de la deuxième électrode de contact manuel. Sa valeur est très élevée, par exemple de plusieurs millions d'Ohms, de manière à ne pas introduire de courant significatif dans la deuxième électrode de contact manuel, et ainsi à ne pas affecter la mesure de la tension de surveillance. Par ailleurs, grâce à l'impédance de mise à la masse, il est possible, en absence de contact de la main simultanément sur la première et la deuxième électrode de contact manuel, d'avoir une tension de surveillance nulle au niveau de la deuxième électrode. La mesure d'une tension $V_{E2}$ nulle permet alors, comme indiqué ci-dessus de déclencher le dispositif d'arrêt d'urgence, ou une simple mise hors service, pour interdire l'utilisation de l'outil. Ainsi, un utilisateur qui ne toucherait pas lors d'une coupe la deuxième électrode, ou qui la toucherait avec un gant isolant par exemple, ne pourrait pas faire fonctionner l'outil, les moyens d'activation du dispositif d'arrêt d'urgence étant inopérants alors à détecter un risque de contact du doigt avec l'organe de coupe.

Il convient de noter que l'utilisateur peut au besoin porter des gants conducteurs électriques, notamment pour se protéger du froid. Il est important toutefois que le contact de la main avec le gant ne génère pas de variations d'impédance significatives, et notamment supérieures aux variations d'un contact direct de la main avec l'électrode de contact manuel.

D'autres caractéristiques et avantages de l'invention ressortent de la description qui suit en référence aux figures des dessins. Cette description est donnée à titre purement illustratif et non limitatif.

**Brève description des figures**

La figure 1, est une représentation schématique simplifiée des principales caractéristiques et fonctions d'un outil de coupe conforme à l'invention.

La figure 2, est une représentation schématique simplifiée d'un sécateur conforme à l'invention.

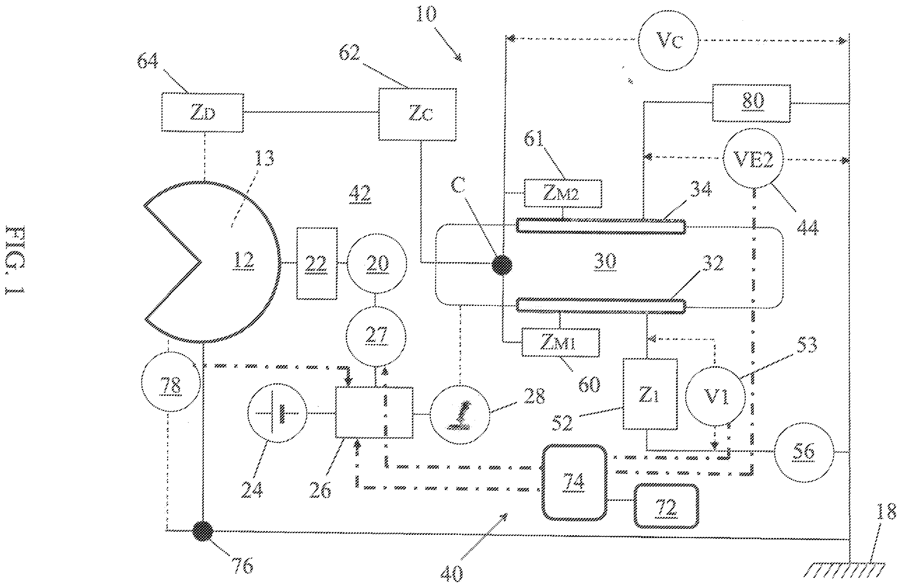

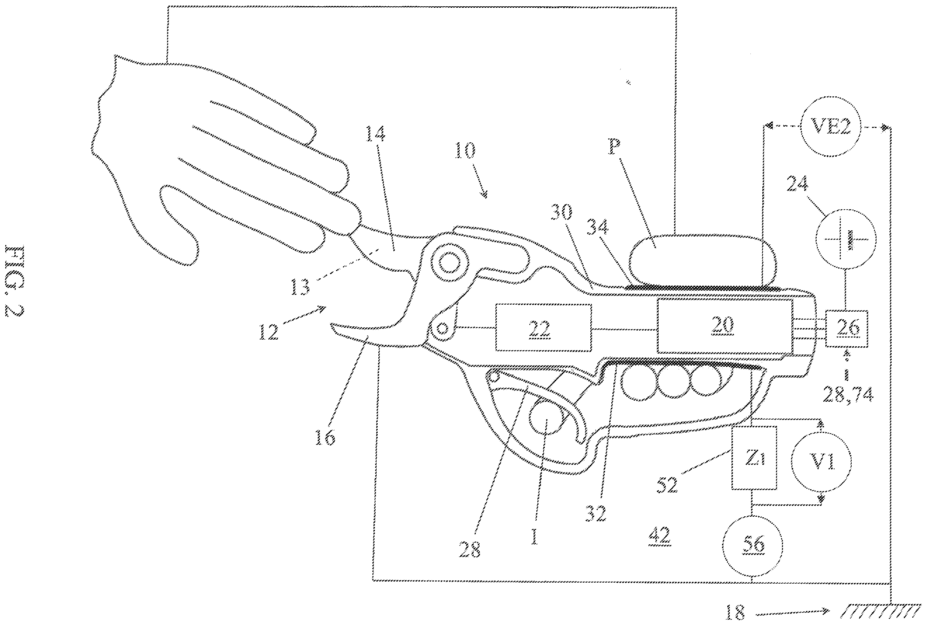

Des parties identiques ou similaires des figures 1 et 2 portent les mêmes références numériques de manière à faciliter le report d'une figure à l'autre et de manière à en répéter la description.

**Description détaillée de modes de mise en œuvre de l'invention**

La figure 1 indique schématiquement un outil de coupe 10 pourvu d'un organe de coupe 12

L'organe de coupe 12 est relié électriquement au potentiel de masse 18 de l'outil.

L'outil de coupe comprend en outre un moteur électrique 20 relié mécaniquement l'organe de coupe 12, par un mécanisme de transmission 22. Le mécanisme de transmission transmet à l'organe de coupe l'énergie mécanique fournie par le moteur. Il permet d'entrainer l'organe de coupe selon un mouvement de pivotement, un mouvement rotatif circulaire ou un mouvement de translation, selon la nature de l'organe de coupe.

Le moteur électrique 20 est associé à une alimentation électrique 24 et à une carte électronique de commande 26 du moteur. La carte électronique de commande 26 peut recevoir des signaux d'un organe de déclenchement de coupe 28 actionnable par une main de l'utilisateur tenant une poignée de saisie 30 de l'outil de coupe 10. L'organe de déclenchement de coupe 28, par exemple une gâchette, est disposée à proximité de la poignée de saisie 30, de manière à pouvoir être actionné par la main qui saisit la poignée.

La poignée de saisie 30 est en matière plastique isolante, et donc isolée électriquement de l'organe de coupe. Elle est pourvue par ailleurs d'une paire d'électrodes de contact manuel 32 et 34 ménagées respectivement sur deux parties sensiblement opposées de la poignée. Les électrodes de contact manuel sont des électrodes métalliques ou des électrodes en matière plastique conductrice, avec lesquelles la main de l'utilisateur vient nécessairement en contact lorsque le sécateur est saisi par sa poignée. Elles sont électriquement isolées l'une de l'autre et sont électriquement isolées de l'organe de coupe 12. L'une de la première ou de la deuxième électrode peut aussi être disposée sur la gâchette de l'organe de déclenchement de coupe, actionné par la main saisissant la poignée.

Un dispositif d'arrêt d'urgence 40 du moteur électrique 20 du sécateur est gouverné par un circuit électrique de surveillance 42. Le circuit électrique de surveillance 42 inclut des composants de l'outil de coupe mais peut également inclure des parties du corps d'un humain utilisant le sécateur 10. Le circuit électrique 42 comprend notamment en série, une impédance d'ajustement 52, la première électrode 32 de contact manuel, l'organe de coupe 12 et un générateur électrique 56 d'un courant de surveillance. Le générateur électrique est par exemple une source de tension, par exemple une pile électrique, ou une source de courant. L'impédance d'ajustement peut être formée d'un ou de plusieurs composants électriques dont la valeur d'impédance électrique est connue. Elle peut être incluse dans le générateur électrique 56. Il s'agit, par exemple, d'une résistance électrique avec une valeur, par exemple, de 100kΩ. Sa valeur n'est toutefois pas critique. Elle peut être comprise, par exemple, entre 1 Ω et 200kΩ. Une mesure de la tension $V_1$ aux bornes de l'impédance d'ajustement permet alors de déterminer le courant de surveillance Is circulant dans le circuit de surveillance.

L'impédance d'ajustement n'est pas nécessaire quand le générateur électrique 56 comprend une source de courant générant directement, lors de la fermeture du circuit électrique de surveillance 42, un courant de valeur définie Is.

En l'absence de contact avec un utilisateur, le circuit électrique de surveillance 42 est normalement un circuit ouvert ayant, par conséquent une impédance globale quasi-infinie et un courant nul.

Lorsqu'un utilisateur saisit la poignée, sa main vient en contact des électrodes de contact manuel et donc de la première électrode de contact manuel 32. Le premier circuit électrique 42 reste ouvert.

En revanche, lorsque l'utilisateur touche également l'organe de coupe 12, par exemple avec un doigt de sa main libre, il ferme le circuit électrique de surveillance 42. Dans ce cas, l'impédance d'ajustement 52 se trouve en série successivement avec la première électrode de contact manuel, une impédance de contact 60 de la main de l'utilisateur avec la première électrode de contact manuel 32, une impédance 62 du corps de l'utilisateur, une impédance de contact 64 du doigt l'organe de coupe, et, finalement l'organe de coupe 12.

Les valeurs de l'impédance de contact 60 de la main, de l'impédance 62 du corps et de l'impédance de contact 64 du doigt avec l'organe de coupe sont notés respectivement $Z_{M1}$, Zc et $Z_D$.

Ainsi lorsque le premier circuit est fermé une impédance totale $Z_T$ est telle que :

$$Z_T = Z_1 + Z_{M1} + Z_C + Z_D$$

L'impédance du câblage et celle de l'organe de coupe sont négligées ici. On néglige également l'impédance du générateur électrique 56 qui est considéré ici comme une source de tension.

Lorsque le circuit électrique de surveillance est fermé, le générateur 56 fait circuler dans le circuit un courant de surveillance Is.

La valeur du courant Is peut être prédéfinie par le générateur de courant lorsqu'il comporte une source de courant. Elle peut aussi être déterminée à partir d'une mesure de tension effectuée aux bornes de l'impédance d'ajustement 52 lorsque le générateur comprend une source de tension, par exemple. La mesure de tension $V_1$ aux bornes de l'impédance d'ajustement 52, de valeur $Z_1$, est effectuée par un voltmètre intégré 53.

Un dispositif de mesure de tension 44, par exemple un autre voltmètre intégré, est connecté entre la masse 18 de l'outil de coupe 10 et la deuxième électrode de contact manuel. Il mesure un potentiel $V_{E2}$, ou plus précisément une tension de surveillance $V_{E2}$ entre la masse 18 et la deuxième électrode de contact manuel 34.

La tension de surveillance $V_{E2}$, de même que la tension délivrée par le voltmètre intégré 53 sont fournies à une unité de gestion numérique 74. L'unité de gestion numérique, par exemple un microcontrôleur, ou un circuit intégré dédié, permet d'effectuer différentes opérations.

Une première opération consiste à calculer le courant de surveillance $I_s$ en effectuant un rapport $V_1/Z_1$.

Une deuxième opération peut consister à calculer une valeur d'impédance Z à partir de la tension de surveillance et du courant de surveillance. En se référant à la description qui précède, on rappelle que :

$$Z = Z_C + Z_D = V_{E2} / I_s.$$

Enfin, et de manière principale, l'unité de gestion numérique 74 constitue un comparateur.

Elle peut notamment être utilisée pour comparer la valeur d'impédance Z à la valeur de seuil $Z_{seuil}$ majorant une valeur d'impédance du corps humain. Elle peut encore être utilisée pour comparer la tension de surveillance VE2 à la tension de seuil $V_{seuil}$ telle que $V_{seuil} = Z_{seuil} \times I_s$.

Lorsque la tension chute sous la valeur de seuil de tension ou lorsque l'impédance chute sous la valeur de seuil d'impédance, la caractéristique électrique de seuil est respectivement franchie et l'arrêt d'urgence est déclenché.

Les comparaisons peuvent être effectuées sur d'autres paramètres fonction des paramètres précités et également calculés par l'unité de gestion numérique 74. Il est possible de comparer des conductances plutôt que des impédances, par exemple.

Suite à la comparaison, et lorsque la caractéristique électrique de seuil est franchie, par valeurs supérieures ou par valeurs inférieures selon la caractéristique choisie, le dispositif d'arrêt d'urgence 40 est déclenché.

Les caractéristiques électriques de seuil utilisés par le comparateur de l'unité de gestion numérique, par exemple les valeurs $V_{seuil}$ ou $Z_{seuil}$, peuvent être stockées dans une mémoire 72 associée à l'unité de gestion numérique 74.

Dans l'exemple de la figure 1 le dispositif d'arrêt d'urgence comporte la carte électronique 26 de commande du moteur électrique. La carte électronique de commande 26 reçoit le signal d'arrêt d'urgence indiqué par un lien en trait mixte. La carte électronique de commande du moteur est dans ce cas configurée pour déclencher un mouvement du moteur propre à contrer le mouvement de l'organe de coupe et/ou de manière à provoquer un freinage électromagnétique du moteur et de l'organe de coupe en utilisant les circuits inductifs du moteur électrique.

Un arrêt quasi instantané du mouvement de l'outil de coupe est ainsi obtenu.

Suite à l'arrêt de l'outil de coupe une coupure de l'alimentation électrique peut également être opérée. Elle peut être effectuée par un interrupteur 27, et en particulier un interrupteur à transistor, piloté par l'unité de gestion numérique 74.

Il convient de noter que l'unité de gestion numérique 74, et en particulier le comparateur qu'elle constitue, de même que la carte électronique 26 de commande du moteur d'actionnement, peuvent être réalisées sous la forme d'un unique composant intégré.

La référence 80 désigne une impédance de mise à la masse. Il s'agit dans l'exemple de la figure 1 d'une résistance électrique de plus de 1MΩ connectée entre la deuxième électrode de contact manuel 34 et masse 18 de l'outil de coupe. Elle permet d'éviter une tension flottante de la deuxième électrode de contact manuel. Elle permet également de fixer la tension de la deuxième électrode de contact manuel à une valeur nulle lorsque la deuxième électrode de contact manuel n'est pas en contact avec la main de l'utilisateur.

La mesure d'une tension de surveillance nulle par le dispositif de mesure de tension 44 peut ainsi être exploitée par l'unité de gestion numérique 74 pour interdire le fonctionnement de l'outil ou pour provoquer un arrêt d'urgence. Dans l'exemple de la figure, l'alimentation électrique du moteur d'actionnement 20 peut simplement être inhibée dans le cas de la mesure d'une tension de surveillance nulle.

Ceci permet, par exemple d'empêcher le fonctionnement de l'outil lorsqu'il est tenu par un utilisateur portant des gants isolants qui empêcheraient la détection d'un contact avec l'organe de coupe.

Quasiment aucun courant ne traverse l'impédance de mise à la masse ou la partie de la main de l'utilisateur en contact avec la deuxième électrode de contact manuel. Ainsi, le potentiel $V_{E2}$ mesuré sur la deuxième électrode de contact manuel est quasiment identique à un potentiel $V_c$ qui serait mesuré entre un point fictif C à l'intérieur du corps de l'utilisateur qui saisit la poignée 30 et l'organe de coupe, et donc la masse de l'outil.

La référence 76 désigne une électrode de contrôle reliée électriquement à l'organe de coupe 12. Elle est prévue pour permettre un test de l'arrêt d'urgence sans toucher l'organe de coupe. Il suffit en effet que l'utilisateur, saisissant la poignée 30, touche simultanément avec sa main libre l'électrode de contrôle 76 pour provoquer un arrêt d'urgence. La carte électronique de commande 26 peut éventuellement être configurée pour requérir une telle opération de contrôle périodique, de manière à garantir le bon fonctionnement du dispositif d'arrêt d'urgence.

Un circuit de surveillance 78 du potentiel de l'organe de coupe est également prévu. Il est construit autour d'un voltmètre et est relié également à la carte électronique de commande 26 du moteur électrique 20 pour provoquer un arrêt d'urgence lorsqu'un potentiel électrique de l'organe de coupe 12 devient différent d'une valeur de consigne. Dans l'exemple de réalisation illustré, on vérifie que le potentiel électrique de l'organe de coupe est au potentiel de masse de l'outil. Le voltmètre peut être un composant intégré faisant partie d'une même carte électronique que l'unité de gestion numérique.

La figure 2 montre un sécateur, avec une coupe partielle laissant apparaître le moteur électrique d'entraînement de l'organe de coupe 12, ainsi que le mécanisme de transmission 22 entre le moteur 20 et une lame mobile 14 de l'organe de coupe 12.

L'organe de coupe 12, comprend, dans le cas du sécateur, une lame fixe 16, ou crochet, et une lame mobile 14, mue par le moteur électrique 20, et se refermant sur la lame fixe suite à une sollicitation de l'organe de déclenchement de coupe 28 qui est ici une gâchette. Un signal de la gâchette est dirigé vers la carte 26 de commande du moteur représentée symboliquement.

La figure 2 Illustre le contact de la main avec la première et la deuxième électrode de contact manuel 32 et 34 lorsque l'utilisateur saisit la poignée de saisie 30 pour une utilisation fonctionnelle du sécateur. On peut noter que les doigts, et plus précisément le majeur, l'annulaire et l'auriculaire viennent en contact avec la première électrode de contact manuel 32 et donc avec le circuit électrique de surveillance. La première électrode de contact manuel 32 est ici disposée sur une partie inférieure de la poignée de saisie 30, dans une position d'utilisation du sécateur.

Le paume P de la main vient en contact avec la deuxième électrode de contact manuel 34 disposée ici sur une partie supérieure de la poignée de saisie 30.

L'index I de la main est libre pour actionner la gâchette 28.

La main libre de l'utilisateur est montrée dans une position où un doigt vient en contact avec l'organe de coupe. La main tenant la poignée de saisie du sécateur 10 et la main venant en contact avec l'organe de coupe sont reliées par un trait symbolisant le corps humain.

La carte électronique de commande 26 du moteur électrique est reliée au moteur électrique de manière à contrôler l'alimentation électrique des différentes phases du moteur. Elle peut être utilisée pour commander la rotation du moteur dans un sens provoquant la fermeture de la lame mobile 14 sur le crochet 16. Elle peut aussi être utilisée, lors d'un arrêt d'urgence, dans un sens de rotation inverse, provoquant l'ouverture de l'organe de coupe, et contrant sa fermeture. Enfin, elle peut être utilisée comme frein électromagnétique, par exemple en mettant en court-circuit les phases du moteur.

La carte électronique de commande est, par ailleurs reliée à une alimentation électrique 24, telle qu'une batterie électrique portée, par exemple, au dos de l'utilisateur.

La figure 2 montre également la tension de surveillance $V_{E2}$ mesurée entre la masse du sécateur et la deuxième électrode de contact manuel 34.

La référence 13 indique un mince revêtement anticorrosion et/ou isolant électrique, tel qu'une couche de PTFE (polytétrafluoroéthylène) susceptible de recouvrir les lames 14, 16 du sécateur. L'usage d'une telle couche d'isolant ne fait pas obstacle au fonctionnement de l'outil de l'invention et notamment ne fait pas obstacle au déclenchement du dispositif d'arrêt d'urgence lorsque le générateur électrique 56 est un générateur de courant alternatif. En effet un courant de surveillance alternatif peut circuler en cas de contact du doigt de l'utilisateur avec les lames 14, 16 du sécateur, en dépit de la couche isolante électrique. Dans ce cas l'impédance $Z_D$ de contact du doigt avec l'outil de coupe, présente une composante capacitive.

## Revendications

**1.** Outil de coupe sécurisé (10) comprenant:

- un organe de coupe (12) conducteur électrique,
- un moteur d'actionnement (20) de l'organe de coupe, commandé électriquement,
- une poignée de saisie (30) de l'outil de coupe par la main d'un utilisateur, la poignée de saisie étant électriquement isolée de l'organe de coupe (12),
- un organe de déclenchement de coupe (28) actionnable par la main de l'utilisateur saisissant la poignée de saisie (30), l'organe de déclenchement de coupe étant électriquement isolé de l'organe de coupe (12),
- un dispositif d'arrêt d'urgence (40) sensible à un contact d'un utilisateur avec l'organe de coupe, au moins une première électrode de contact manuel (32),

**caractérisé par** :

- au moins une deuxième électrode de contact manuel (32, 34), la première électrode de contact manuel (32) et la deuxième électrode de contact manuel (34) étant électriquement isolées l'une de l'autre, et ménagées sur au moins l'une de la poignée de saisie de l'outil (30) et de l'organe de déclenchement de coupe (28), de manière à être touchées simultanément par la main de l'utilisateur lorsqu'il saisit la poignée de saisie,
- un circuit électrique de surveillance (42) comprenant la première électrode de contact manuel (32) et l'organe de coupe (12), le circuit électrique de surveillance (42) étant susceptible d'être fermé, lors d'un contact simultané de l'utilisateur avec ladite première électrode de contact manuel (32) et avec l'organe de coupe (12),
- un générateur électrique (56) d'un courant de surveillance dans le premier circuit électrique (42),
- un dispositif de mesure (44) d'une tension de surveillance ($V_{E2}$) entre l'organe de coupe (12) et la deuxième électrode de contact manuel (34),
- un comparateur (74) d'au moins une caractéristique électrique de surveillance fonction de la tension de surveillance et d'une caractéristique électrique de seuil fonction d'une valeur d'impédance majorant une valeur d'impédance de conduction du corps humain, le comparateur (74) étant relié au dispositif (40) d'arrêt d'urgence du moteur d'actionnement (20) de l'organe de coupe, pour provoquer un arrêt d'urgence lorsque la caractéristique électrique de surveillance franchit la caractéristique électrique de seuil.

**2.** Outil de coupe selon la revendication 1, dans lequel la caractéristique électrique de surveillance est une tension fonction de la tension de surveillance et dans lequel la caractéristique électrique de seuil est une tension de seuil fonction de la valeur d'impédance majorant une valeur d'impédance de conduction du corps humain et du courant de surveillance.

**3.** Outil de coupe selon l'une quelconque des revendications 1 ou 2, dans lequel la caractéristique électrique de surveillance est la tension de surveillance et dans lequel la caractéristique électrique de seuil est égale au produit de la valeur d'impédance majorant une valeur d'impédance de conduction du corps humain et du courant de surveillance.

**4.** Outil de coupe selon la revendication 1, dans lequel la caractéristique électrique de surveillance est une valeur d'impédance fonction de la tension de surveillance et du courant de surveillance, et dans lequel la caractéristique de seuil est une valeur d'impédance fonction de la valeur d'impédance majorant une valeur d'impédance de conduction du corps humain.

**5.** Outil de coupe selon l'une quelconque des revendications 1 ou 4, dans lequel la caractéristique électrique de surveillance est égale au rapport de la tension de surveillance sur le courant de surveillance, et dans lequel la caractéristique de seuil est égale à la valeur d'impédance majorant une valeur d'impédance de conduction du corps humain.

**6.** Outil de coupe selon l'une quelconque des revendications précédentes, dans lequel le générateur électrique (56) est un générateur générant un courant alternatif.

**7.** Outil de coupe selon l'une quelconque des revendications précédentes dans lequel le générateur électrique (56) comporte une source de courant.

**8.** Outil de coupe selon l'une quelconque des revendications 1 à 6, dans lequel le générateur électrique (56) comporte une source de tension.

**9.** Outil de coupe selon l'une quelconque des revendications précédentes comprenant, en série dans le circuit électrique, une impédance électrique d'ajustement, présentant une valeur d'impédance prédéterminée et un dispositif de mesure (53) d'une tension aux bornes de l'impédance électrique d'ajustement.

**10.** Outil de coupe selon les revendications 7 et 9, dans lequel la source de courant est connectée en parallèle à l'impédance d'ajustement.

**11.** Outil de coupe selon l'une quelconque des revendications précédentes comprenant un dispositif (78) de surveillance d'un potentiel électrique de l'organe de coupe, le dispositif de surveillance du potentiel électrique étant relié au dispositif d'arrêt d'urgence (40) pour provoquer un arrêt d'urgence lorsque le potentiel électrique de l'organe de coupe est hors d'une plage de consigne.

**12.** Outil de coupe selon l'une quelconque des revendications précédentes, dans lequel l'organe de coupe (12) est relié à un potentiel de masse (18) de l'outil.

**13.** Outil de coupe selon l'une quelconque des revendications précédentes, dans lequel le moteur d'actionnement (20) est un moteur thermique.

**14.** Outil de coupe selon l'une quelconque des revendications 1 à 12, dans lequel le moteur d'actionnement de l'organe de coupe est un moteur électrique, et dans lequel le dispositif d'arrêt d'urgence comprend une carte électronique de pilotage du moteur.

**15.** Outil de coupe selon l'une quelconque des revendications précédentes comprenant une impédance (80) de mise à la masse, d'une valeur dépassant de plusieurs ordres de grandeur la valeur d'impédance majorant la valeur d'impédance du corps humain, l'impédance de mise à la masse reliant électriquement la deuxième électrode de contact manuel à l'organe de coupe, et configuré pour provoquer en outre l'un parmi un arrêt d'urgence et une mise hors service, lorsque la tension de surveillance ($V_{E2}$) mesurée par le dispositif de mesure (44) est nulle.

**Patentansprüche**

**1.** Gesichertes Schneidwerkzeug (10), umfassend:

- ein elektrisch leitendes Schneidorgan (12),
- einen elektrisch gesteuerten Betätigungsmotor (20) des Schneidorgans,
- einen Griff (30) des Schneidwerkzeugs zum Ergreifen durch die Hand eines Benutzers, wobei der Griff vom Schneidorgan (12) elektrisch isoliert ist,
- ein das Schneiden auslösendes Organ (28), das durch die Hand des Benutzers betätigbar ist, die den Griff (30) ergreift, wobei das das Schneiden auslösende Organ vom Schneidorgan (12) elektrisch isoliert ist,
- eine Notaus-Vorrichtung (40), die für einen Kontakt eines Benutzers mit dem Schneidorgan empfindlich ist,
- mindestens eine erste manuelle Kontaktelektrode (32),

**gekennzeichnet durch**:

- mindestens eine zweite manuelle Kontaktelektrode (32, 34), wobei die erste manuelle Kontaktelektrode (32) und die zweite manuelle Kontaktelektrode (34) voneinander elektrisch isoliert sind und auf mindestens auf einem von dem Griff des Werkzeugs (30) und dem das Schneiden auslösenden Organ (28) derart eingerichtet sind, dass sie von der Hand des Benutzers gleichzeitig berührt werden, wenn er den Griff ergreift,
- einen elektrischen Überwachungskreis (42), der die erste manuelle Kontaktelektrode (32) und das Schneidorgan (12) umfasst, wobei der elektrische Überwachungskreis (42) imstande ist, bei einem gleichzeitigen Kontakt des Benutzers mit der ersten manuellen Kontaktelektrode (32) und mit dem Schneidorgan (12) geschlossen zu sein,
- einen Stromerzeuger (56) eines Überwachungsstroms im ersten Stromkreis (42),
- eine Messvorrichtung (44) einer Überwachungsspannung ($V_{E2}$) zwischen dem Schneidorgan (12) und der zweiten manuellen Kontaktelektrode (34),
- einen Komparator (74) von mindestens einem elektrischen Überwachungsmerkmal als Funktion der Überwachungsspannung und einem elektrischen Schwellenwertmerkmal als Funktion eines Impedanzwerts, der einen Leitungs-Impedanzwert des menschlichen Körpers erhöht, wobei der Komparator (74) mit der Notaus-Vorrichtung (40) des Betätigungsmotors (20) des Schneidorgans verbunden ist, um ein Notaus hervorzurufen, wenn das elektrische Überwachungsmerkmal das elektrische Schwellenwertmerkmal überschreitet.

2. Schneidwerkzeug nach Anspruch 1, wobei das elektrische Überwachungsmerkmal eine Spannung als Funktion der Überwachungsspannung ist und wobei das elektrische Schwellenwertmerkmal eine Schwellenwertspannung als Funktion des Impedanzwerts ist, der einen Leitungs-Impedanzwert des menschlichen Körpers erhöht, und des Überwachungsstroms.

3. Schneidwerkzeug nach einem der Ansprüche 1 oder 2, wobei das elektrische Überwachungsmerkmal die Überwachungsspannung ist und wobei das elektrische Schwellenwertmerkmal gleich dem Produkt des Impedanzwerts, der einen Leitungs-Impedanzwert des menschlichen Körpers erhöht, und des Überwachungsstroms ist.

4. Schneidwerkzeug nach Anspruch 1, wobei das elektrische Überwachungsmerkmal ein Impedanzwert als Funktion der Überwachungsspannung und des Überwachungsstroms ist und wobei das Schwellenwertmerkmal ein Impedanzwert als Funktion des Impedanzwerts ist, der einen Leitungs-Impedanzwert des menschlichen Körpers erhöht.

5. Schneidwerkzeug nach einem der Ansprüche 1 oder 4, wobei das elektrische Überwachungsmerkmal gleich dem Verhältnis der Überwachungsspannung zum Überwachungsstrom ist und wobei das Schwellenwertmerkmal gleich dem Impedanzwert ist, der einen Leitungs-Impedanzwert des menschlichen Körpers erhöht.

6. Schneidwerkzeug nach einem der vorangehenden Ansprüche, wobei der Stromerzeuger (56) ein Erzeuger ist, der einen Wechselstrom erzeugt.

7. Schneidwerkzeug nach einem der vorangehenden Ansprüche, wobei der Stromerzeuger (56) eine Stromquelle aufweist.

8. Schneidwerkzeug nach einem der Ansprüche 1 bis 6, wobei der Stromerzeuger (56) eine Spannungsquelle aufweist.

9. Schneidwerkzeug nach einem der vorangehenden Ansprüche, umfassend, in Reihe im Stromkreis, eine elektrische Anpassungsimpedanz, die einen vorher festgelegten Impedanzwert aufweist, und eine Messvorrichtung (53) einer Spannung an den Klemmen der elektrischen Anpassungsimpedanz.

10. Schneidwerkzeug nach den Ansprüchen 7 und 9, wobei die Stromquelle mit der Anpassungsimpedanz parallel geschaltet ist.

11. Schneidwerkzeug nach einem der vorangehenden Ansprüche, umfassend eine Überwachungsvorrichtung (78) eines elektrischen Potentials des Schneidorgans, wobei die Überwachungsvorrichtung des elektrischen Potentials mit der Notaus-Vorrichtung (40) verbunden ist, um ein Notaus hervorzurufen, wenn das elektrische Potential des Schneidorgans außerhalb eines Sollwertbereichs ist.

12. Schneidwerkzeug nach einem der vorangehenden Ansprüche, wobei das Schneidorgan (12) mit einem Massepotential (18) des Werkzeugs verbunden ist.

13. Schneidwerkzeug nach einem der vorangehenden Ansprüche, wobei der Betätigungsmotor (20) ein Verbrennungsmotor ist.

14. Schneidwerkzeug nach einem der Ansprüche 1 bis 12, wobei der Betätigungsmotor des Schneidorgans ein Elektromotor ist und wobei die Notaus-Vorrichtung eine elektronische Steuerkarte des Motors umfasst.

15. Schneidwerkzeug nach einem der vorangehenden Ansprüche, umfassend eine Erdungsimpedanz (80) mit einem Wert, der den Impedanzwert, der den Impedanzwert des menschlichen Körpers erhöht, um mehrere Größenordnungen übersteigt, wobei die Erdungsimpedanz, die die zweite manuelle Kontaktelektrode mit dem Schneidorgan verbindet, und ausgelegt ist, um ferner entweder ein Notaus oder eine Außerbetriebnahme hervorzurufen, wenn die von der Messvorrichtung (44) gemessene Überwachungsspannung ($V_{E2}$) null ist.

**Claims**

1. A safety cutting device (10) comprising:

   - an electrically conductive cutting member (12),
   - a motor (20) for actuating the cutting member, which is electrically controlled,
   - a handle (30) for gripping the cutting device by the hand of a user, the gripping handle being electrically isolated from the cutting member (12),
   - a cutting trigger member (28) operable by the hand of the user gripping the gripping handle (30), the cutting trigger member being electrically isolated from the cutting member (12),
   - an emergency stop device (40) that is sensitive to a user making contact with the cutting member,

- at least a first manual contact electrode (32),

**characterised by**:

at least a second manual contact electrode (32, 34), the first manual contact electrode (32) and the second manual contact electrode (34) being electrically isolated from each other, and arranged over at least one of the gripping handle (30) of the tool and the cutting trigger member (28), so as to be simultaneously touched by the hand of the user when gripping the gripping handle,

- an electrical monitoring circuit (42) comprising the first manual contact electrode (32) and the cutting member (12), the electrical monitoring circuit (42) being capable of being closed, during simultaneous contact of the user with said first manual contact electrode (32) and with the cutting member (12),
- an electric generator (56) of a monitoring current in the first electric circuit (42),
- a device (44) for measuring a monitoring voltage ($V_{E2}$) between the cutting element (12) and the second manual contact electrode (34),
- a comparator (74) for comparing at least one electrical monitoring characteristic depending on the monitoring voltage with an electrical threshold characteristic depending on an impedance value increasing a conduction impedance value of the human body, the comparator (74) being connected to the emergency stop device (40) of the actuating motor (20) of the cutting member, to cause an emergency stop when the electrical monitoring characteristic crosses the electrical threshold characteristic.

2. The cutting device according to claim 1, wherein the electrical monitoring characteristic is a voltage depending on the monitoring voltage and wherein the electrical threshold characteristic is a threshold voltage depending on the impedance value increasing a value of conduction impedance of the human body and of the monitoring current.

3. The cutting device according to any one of claims 1 or 2, wherein the electrical monitoring characteristic is the monitoring voltage and wherein the electrical threshold characteristic is equal to the product of the impedance value increasing a value of conduction impedance of the human body and of the monitoring current.

4. The cutting device according to claim 1, wherein the electrical monitoring characteristic is an impedance value depending on the monitoring voltage and the monitoring current, and wherein the threshold characteristic is an impedance value depending on the impedance value increasing a conduction impedance value of the human body.

5. The cutting device according to any one of claims 1 or 4, wherein the electrical monitoring characteristic is equal to the ratio of the monitoring voltage to the monitoring current, and wherein the threshold characteristic is equal to the impedance value increasing a conduction impedance value of the human body.

6. The cutting device according to any one of the preceding claims, wherein the electric generator (56) is an alternating current generator.

7. The cutting device according to any one of the preceding claims wherein the electric generator (56) includes a current source.

8. The cutting device according to any one of claims 1 to 6, wherein the electric generator (56) includes a voltage source.

9. The cutting device according to any one of the preceding claims comprising, in series in the electrical circuit, an electrical adjustment impedance, having a predetermined impedance value and a device (53) for measuring a voltage at the terminals of the electrical adjustment impedance.

10. The cutting device according to claims 7 and 9, wherein the current source is connected in parallel with the adjustment impedance.

11. The cutting device according to any one of the preceding claims comprising a device (78) for monitoring an electrical potential of the cutting member, the electrical potential monitoring device being connected to the emergency stop device (40) to trigger an emergency stop when the electrical potential of the cutting organ is outside a reference range.

12. The cutting device according to any one of the preceding claims, wherein the cutting member (12) is connected to a ground potential (18) of the tool.

13. The cutting device according to any one of the preceding claims, wherein the actuating motor (20) is a thermal motor.

14. The cutting device according to any one of claims 1 to 12, wherein the actuating motor of the cutting member is an electric motor, and wherein the emergency stop device comprises an electronic board for driving the motor.

15. The cutting device according to any one of the preceding claims comprising a grounding impedance (80), of a value exceeding by several orders of magnitude the impedance value increasing the impedance value of the human body, the ground impedance electrically connecting the second manual contact electrode to the cutting member, and configured to further cause one of emergency stop and shutdown, when the monitoring voltage ($V_{E2}$) measured by the measuring device (44) is zero.

FIG. 1

FIG. 2

## RÉFÉRENCES CITÉES DANS LA DESCRIPTION

**Documents brevets cités dans la description**

- FR 2712837
- FR 2779669
- FR 2831476
- FR 2838998
- FR 2846729
- FR 2963081

- FR 3001404
- EP 2490865 A
- EP 2825811 A
- US 5025175 A
- US 7365955 B
- WO 2012025456 A